# FASCICULE DE BREVET EUROPEEN

(11) **EP 0 403 343 B1**
(45) Date de publication et mention de la délivrance du brevet: **10.08.1994**
(21) Numéro de dépôt: 90401574.0
(22) Date de dépôt: 08.06.1990
(51) Int. Cl.: H01L 25/16

(54) **Circuit hybride fonctionnant sous haute tension**
Unter hoher Spannung funktionierende Hybridschaltung
Hybrid circuit functioning under high voltage

(30) Priorité: 16.06.1989 FR 8908016
(43) Date de publication de la demande: 19.12.1990
(73) Titulaire: THOMSON HYBRIDES, 92800 Puteaux (FR)
(72) Inventeur: Rousseau, Claude, F-92045 Paris La Défense (FR); Morelle, Jean-Michel, F-92045 Paris La Défense (FR)
(74) Mandataire: Taboureau, James

(56) Documents cités:
- PATENT ABSTRACTS OF JAPAN, vol. 7, no. 45 (E-160), 23 février 1983 ; & JP-A-57 196 537
- PATENT ABSTRACTS OF JAPAN, vol. 6, no. 211 (E-137), 23 novembre 1982 ; & JP-A-57 115 851
- PATENT ABSTRACTS OF JAPAN, vol. 5, no. 133 (E-71), 25 août 1981 ; & JP-A-56 69 858

## Description

La présente invention concerne un circuit hybride, adapté pour travailler sous de fortes tensions sans risques de claquage. Elle concerne de préférence les circuits hybrides de puissance, pour lesquels une tension élevée est appliquée afin d'augmenter la puissance délivrée par le module de circuit hybride.

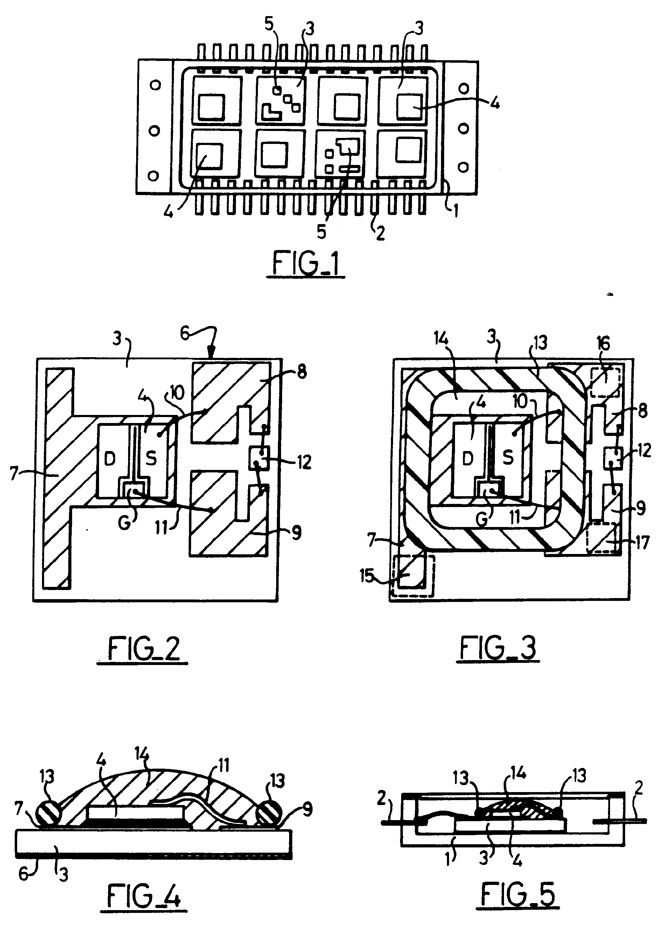

Généralement, les modules de puissance sont réalisés dans un boîtier métallique tel que représenté en plan en figure 1, le couvercle étant enlevé. Ce boîtier 1 est en métal épais et bon conducteur de la chaleur, de façon à bien dissiper les calories dégagées en cours de fonctionnement. Il est muni de moyens de fixation sur un dissipateur, et comporte une pluralité de connexions d'accès extérieur 2, qui, sur cette figure, traversent les cloisons latérales du boîtier 1. Las connexions 2 pouvant également traverser le fond du boîtier, ou être repliées à angle droit, à l'extérieur.

La circuit hybride encapsulé dans ce boîtier peut être monolithique, sur un substrat d'alumine ou d'oxyde de béryllium, mais dans le cas d'un circuit de puissance, et surtout s'il est alimenté sous haute tension, il est préférable qu'il soit fractionné en plusieurs éléments, dits porteurs de puces.

Chaque élément 3 de substrat supporte soit une puce 4 de transistor de puissance, par exemple, soit une pluralité de composants 5 de signal, capacités, diodes etc... , ainsi que les métallisations d'interconnexions de tous ces composants entre eux.

Pour clarifier la figure, ces interconnexions ainsi que les fils de connexions aux bornes d'accès extérieur 2 ne sont pas représentées.

Ce type de montage, par porteurs de puces, permet de tester séparément chaque composant avant assemblage dans le boîtier.

La tendance naturelle en électronique des semiconducteurs est de densifier au maximum les circuits, mais, si le circuit hybride doit fonctionner sous haute tension, par exemple 1000 V, le risque est grand qu'il y ait des claquages en tension entre les fils d'interconnexions des puces, les pistes métallisées déposées sur les éléments de substrat 3, et le boîtier 1 qui est normalement à la masse. En effet, les distances entre des éléments portés à des potentiels différents sont courtes, et ces éléments baignent dans l'air, dont la rigidité diélectrique est de l'ordre de 1000 V/mm.

Afin de pouvoir faire fonctionner un tel module hybride sous de fortes tensions, sans perdre sur la compacité du circuit, et sans augmenter les dimensions du boîtier, l'invention propose d'enrober au moins l'un des porteurs de puces, s'il n'y en a qu'un qui soit alimenté sous haute tension, au moyen d'une résine organique de rigidité diélectrlque élevée, par exemple 20 000 V/mm, en tous cas plus élevée que celle de l'air. Cette résine est coulée sur la face du support de puce qui porte le composant haute tension, l'autre face, métallisée, étant brasée sur le fond du boîtier. Pour obtenir une épaisseur de résine suffisante pour y noyer les fils d'interconnexions, et pour obtenir une géométrie définie en surface du porteur de puce, cette réslne qui est à l'origine fluide, avant sa polymérisation, est coulée à l'intérieur d'un cordon, conforme à la géométrie désirée, formé par une autre résine plus pâteuse. Las différentes qualités de résines silicones disponibles répondent bien à ces impératifs.

De façon plus précise, l'invention concerne un circuit hybride selon la revendication 1.

L'invention sera mieux comprise, sa simplicité et ses avantages ressortiront mieux de la description plus détaillée qui suit, en s'appuyant sur les figures jointes en annexes, qui représentent :
- Figure 1 : vue en plan d'un boîtier de circuit hybride, selon l'art connu, détaillé précédemment ;
- Figure 2 : vue en plan d'un porteur de puce, qui sert de base à la protection haute tension selon l'invention ;
- Figure 3 : le porteur de puce de la figure 2, muni de la protection selon l'invention ;
- Figure 4 : vue en coupe du porteur de puce de la figure 3 ;
- Figure 5 : vue en coupe d'un module de circuit hybride haute tension, dans son boîtier, selon l'invention.

De façon à être plus claire, l'invention sera exposée en s'appuyant sur le cas d'un porteur de puce de transistor de puissance, soit un MOS, soit un bipolaire, mais il est bien entendu que l'invention s'applique à tout composant tel que transistor de signal, diode, ou pavé de capacité, alimenté sous haute tension. Par haute tension on entend de l'ordre d'au moins 800 à 1000 V.

La figure 2 représente, vu en plan, un porteur de puce avant sa protection haute tension. C'est un substrat 3, sensiblement carrée, d'alumine, oxyde de béryllium ou nitrure d'aluminium, dont la face inférieure est métallisée en 6 -visible sur la figure 4 - en vue de sa brasure dans le boîtier 1.

La face supérieure du substrat 3 supporte une puce 4 de transistor de puissance, elle-même brasée par sa face arrière sur une métallisation 7 déposée sur le substrat 3 : ladite métallisation 7 assure, par exemple, le contact de drain du transistor 4 si c'est un transistor à effet de champ. Deux autres métallisations 8 et 9 sont déposées sur la face supérieure du substrat 3 : l'une est connectée par un fil métallique 10 à la source du transistor 4, et l'autre est connectée par un fil métallique 11 à la grille du transistor. Un composant 12, tel que self ou capacité, est souvent interconnecté entre grille et source.

En raison de la haute tension en service, les trois métallisations 7, 8 et 9 sont déposées le long des bords du substrat 3, pour établir le plus grand espace possible entre elles, mais il n'en demeure pas moins que :
- la métallisation 7 est au potentiel de drain V_{D}
- la métallisation 8 est au potentiel de source V_{S}
- la métallisation 9 est au potentiel de grille V_{G}

et que les différences de potentiel V_{D}-V_{G} et V_{D}-V_{S} peuvent être importantes : 1000 V ou plus.

Cependant, la rigidité diélectrique de l'air, de l'ordre de 1000 Vmm⁻¹, impose une distance minimale entre les métallisations 7, 8 et 9, tandis que la géométrie du composant impose une limite en tension dans son utilisation. La distance dans l'air entre les métallisations de grille et source, sur la face supérieure de la puce de transistor 4 et la métallisation de drain, sur la face inférieure de la même puce, est d'environ 1 mm, soit 1000 V maximum : 400 µm du bord de la puce, plus 600 µm d'épaisseur de puce.

Il est possible d'augmenter la tension de service, donc la puissance délivrée, au moyen d'une protection localisée selon l'invention, dont une forme préférée est représentée en figure 3.

Une forme simple consiste à recouvrir la face supérieure de la puce du transistor 4 par une couche de résine sillcone, qui enrobe les métallisations de grille et source, augmentant la tension de claquage par fuite en surface de la puce, vers la métallisation de drain. Mais cela n'empêche pas un éventuel claquage en tension entre les fils 10 et 11 et la métallisation 7, ou entre les métallisations 8 et 9 et la métallisation 7.

C'est pourquoi l'invention comporte un cordon 13 d'une première réslne sillcone, ou de toute autre résine ayant des propriétés comparables, qui entoure la puce de transistor 4, et recouvre partiellement les métallisations 7, 8 et 9 de reprises de contacts. Cette première résine, déposée à la seringue, doit avoir une viscosité suffisante pour ne pas fluer, mais au contraire former un barrage. La forme géométrique donnée au cordon 13 peut être irrégulière, et commandée par des impératifs technologiques. En particulier, elle doit réserver des plages telles que 15, 16 et 17 sur les métallisations 7, 8 et 9 : ces plages sont destinées d'abord au test en puissance du composant 4, avant son brasage dans le boîtier 1, ensuite au câblage de fils d'interconnexions entre porteurs de puces assemblés dans le boîtier.

A l'intérieur de ce cordon 13 est coulée une seconde résine silicone 14, qui noie la surface de la puce 4, les fils de contacts 10 et 11, et les surfaces de métallisations 7, 8 et 9 comprises à l'intérieur du cordon 13. Cette seconde résine 14 doit être fluide, de haute pureté ionique, et avoir une rigidité diélectrique élevée, par exemple 20.000 Vmm⁻¹. Ainsi, à l'intérieur du volume délimité par le cordon 13, il n'y a plus d'air, et les matériaux sont soit le substrat 3, soit une résine, tous deux à constante diélectrlque élevée.

La figure 4, en coupe, permet de mieux voir la seconde résine 14, qui se distingue mal sur la figure 3, en plan.

La protection localisée selon l'invention permet de gagner en densité d'intégration, puisque les espacements de 1000 Vmm⁻¹ dans l'air deviennent 15 000 ou 20 000 Vmm⁻¹ sous protection localisée par résine, ce qui permet de réduire les intervalles entre pistes conductrices, jusqu'aux limites de la technologie utilisée : 200 µm pour les métallisations en couches épaisses, 50 µm pour les couches minces.

De la même façon, les pistes conductrices déposées sur le substrat 3, et extérieures à la zone protégée sous résine 13 + 14, peuvent avantageusement être protégées par un isolant de surface déposé par exemple par sérigraphie, hors des plages de test 15, 16 et 17.

La protection localisée selon l'invention permet de monter des porteurs de puces fonctionnant sous haute tension dans des boîtiers métalliques de faible épaisseur, comme le montre la figure 6. Las parties conductrices étant noyées dans une résine à grande rigidité diélectrique, il n'y a plus de risque de claquage en tension avec le couvercle du boîtier. Ce risque est ainsi limité au niveau des traversées de cloisons par les connexions 2 d'accès extérieur, mais ceci sort du domaine de l'invention.

D'après son fondement même, l'invention est applicable quels que soient le substrat, le ou les composants protégés, les technologies utilisées pour déposer des métallisations ou souder des fils. La seule contrainte est l'exigence d'une bonne adhérence des résines sur le substrat du porteur de puce.

L'invention est appliquée préférentiellement aux circuits hybrides de puissance, formés par une pluralité d'éléments testables séparément, et interchangeables en cas de nécessité, sans que la totalité du circuit hybride soit de ce fait rebutée. Elle est définie par les revendications suivantes.

## Revendications

1. Circuit hybride fonctionnant sous haute tension, comportant, à l'intérieur d'un boîtier, une pluralité de porteurs de puces, dont chacun comprend un substrat (3), au moins un composant (4) brasé sur le substrat (3), et des métallisations (7,8,9) de prises de contacts sur le substrat ainsi que des fils (10,11) d'interconnexion du composant (4) avec lesdites métallisations (7,8,9), ce circuit hybride étant caractérisé en ce que au moins l'un des porteurs de puces, alimenté sous haute tension, est protégé localement par un enrobage de la face du substrat (3) qui porte le composant (4), le dit enrobage recouvrant le composant (4), les fils d'interconnexion (10,11) et partiellement les métallisations de prises de contacts (7,8,9), et étant constitué par un cordon extérieur (13) d'une première résine de viscosité élevée, déposé sur les métallisations, et par un remplissage (14) d'une deuxième résine, fluide avant polymérisation et de haute pureté ionique à l'intérieur du cordon (13) et au dessus du composant (4), ces deux résines étant à grande rigidité diélectrique supérieure à 15 000 Vmm⁻¹.

2. Circuit hybride selon la revendication 1, caractérisé en ce que le cordon extérieur (13) de l'enrobage épargne, sur les métallisations (7,8,9) déposées sur le substrat (3), des plages (15,16,17) de prises de tests et d'interconnexions.

3. Circuit hybride selon la revendication 1, caractérisé en ce que, en raison de la présence de matériaux à grande rigidité diélectrique autour du composant (4), des métallisations (7,8,9) et des fils d'interconnexions (10,11), les distances entre parties portées à haute tension sont réduites, dans le rapport de la rigidité diélectrique des résines (15-20.000 Vmm⁻¹) à la rigidité diélectrique de l'air (1000 Vmm⁻¹).

4. Circuit hybride selon la revendication 1, caractérisé en ce que les métallisations situées sur le substrat (3) en dehors de la région protégée par les dites résines (13+14), sont protégées en surface par une couche d'isolant sérigraphiée.

5. Circuit hybride selon l'une quelconque des revendications 1 à 4, caractérisé en ce que les première (13) et deuxième (14) résines sont des silicones.

## Patentansprüche

1. Unter hoher Spannung arbeitende Hybridschaltung, die im Inneren eines Gehäuses mehrere Chip-Träger enthält, die jeweils ein Substrat (3), wenigstens ein auf das Substrat (3) gelötetes Bauelement (4) und Kontaktierungsmetallisierungen (7, 8, 9) auf dem Substrat sowie Drähte (10, 11) zum Verbinden des Bauelements (4) mit den Metallisierungen (7, 8, 9) aufweist, wobei die Hybridschaltung dadurch gekennzeichnet ist, daß wenigstens einer der Chip-Träger, der mit Hochspannung gespeist ist, örtlich durch eine Einbettung der Fläche des das Bauelement (4) tragenden Substrats (3) geschützt ist, wobei die Einbettung das Bauelement (4), die Verbindungsdrähte (10, 11) und teilweise die Kontaktierungsmetallisierungen (7, 8, 9) bedeckt und von einem äußeren Band (13) aus einem ersten, auf den Metallisierungen angebrachten Harz mit hoher Viskosität und einer Füllung (14) eines vor der Polymerisierung fließfähigen zweiten Harzes mit hoher Ionenreinheit innerhalb des Bandes (13) und über dem Bauelement (4) gebildet ist, wobei diese zwei Harze über 15000 Vmm⁻¹ eine große dielektrische Festigkeit haben.

2. Hybridschaltung nach Anspruch 1, dadurch gekennzeichnet, daß das äußere Band (13) der Einbettung auf den auf dem Substrat (3) angebrachten Metallisierungen (7, 8, 9) Test- und Anschlußbereiche freiläßt.

3. Hybridschaltung nach Anspruch 1, dadurch gekennzeichnet, daß wegen der Anwesenheit von Materialien mit großer dielektrischer Festigkeit um das Bauelement (4), der Metallisierungen (7, 8, 9) und der Verbindungsdrähte (10, 11) die Abstände zwischen den an Hochspannung gelegten Teilen im Verhältnis der dielektrischen Festigkeit der Harze (15-20000 Vmm⁻¹) zur dielektrischen Festigkeit von Luft (1000 Vmm⁻¹) reduziert sind.

4. Hybridschaltung nach Anspruch 1, dadurch gekennzeichnet, daß die auf dem Substrat (3) befindlichen Metallisierungen außerhalb des durch die Harze (13+14) geschützten Bereichs auf der Oberfläche durch eine durch Siebdruck aufgebrachte Isolierschicht geschützt sind.

5. Hybridschaltung nach einem der Ansprüche 1 bis 4, dadurch gekennzeichnet, daß das erste Harz (13) und das zweite Harz (14) Siliconharze sind.

## Claims

1. Hybrid circuit functioning under high voltage, including, inside a package, a plurality of chip carriers, each of which comprises a substrate (3), at least one component (4) soldered to the substrate (3), and contact-making metallizations (7, 8, 9) on the substrate as well as wires (10, 11) for interconnecting the component (4) with the said metallizations (7, 8, 9), this hybrid circuit being characterized in that at least one of the chip carriers, supplied under high voltage, is protected locally by a coating of that face of the substrate (3) which carries the component (4), the said coating covering the component (4), the interconnection wires (10, 11) and, partially, the contact-making metallizations (7, 8, 9), and being constituted by an external bead (13) of a first resin having a high viscosity, deposited on the metallizations, and by a filling (14) with a second resin, which is fluid before polymerization and is of high ionic purity, inside the bead (13) and above the component (4), these two resins having high dielectric strength, greater than 15 kVmm⁻¹.

2. Hybrid circuit according to Claim 1, characterized in that the external bead (13) of the coating on the metallizations (7, 8, 9) deposited on the substrate (3), spares areas (15, 16, 17) for test connections and for interconnections.

3. Hybrid circuit according to Claim 1, characterized in that, by reason of the presence of materials having high dielectric strength around the component (4), of the metallizations (7, 8, 9) and of the interconnection wires (10, 11), the distances between parts raised to high voltage are reduced in the ratio of the dielectric strength of the resins (15-20 kVmm⁻¹) to the dielectric strength of air (1 kVmm⁻¹).

4. Hybrid circuit according to Claim 1, characterized in that the metallizations located on the substrate (3) outside the region protected by the said resins (13 + 14) are surface-protected by a screen-printed insulating layer.

5. Hybrid circuit according to any one of Claims 1 to 4, characterized in that the first (13) and second (14) resins are silicones.
